Europäisches Patentamt

European Patent Office

Office européen des brevets

(11) Numéro de publication : **0 408 435 B1**

(12) **FASCICULE DE BREVET EUROPEEN**

(45) Date de publication du fascicule du brevet :
30.12.92 Bulletin 92/53

(51) Int. Cl.⁵ : **C04B 35/52,** C04B 41/87,
C04B 35/80

(21) Numéro de dépôt : **90401972.6**

(22) Date de dépôt : **09.07.90**

(54) **Perfectionnement aux outillages permettant d'effectuer l'infiltration en phase vapeur d'un matériau au sein de préformes fibreuses, en vue de la fabrication de pièces composites.**

(30) Priorité : **11.07.89 FR 8909336**

(43) Date de publication de la demande :
16.01.91 Bulletin 91/03

(45) Mention de la délivrance du brevet :
30.12.92 Bulletin 92/53

(84) Etats contractants désignés :
DE GB

(56) Documents cités :
CH-A- 436 092
GB-A- 2 028 230
US-A- 3 991 248

(73) Titulaire : **SOCIETE EUROPEENNE DE PROPULSION**
**24 rue Salomon de Rothschild**
**F-92150 Suresnes (FR)**

(72) Inventeur : **Martinez, Manuel**
**3 allée des Platanes, Appartement 231**
**F-33700 Mérignac (FR)**
Inventeur : **Bouvier, Francis**
**12, rue Domion**
**F-33200 Bordeaux (FR)**

(74) Mandataire : **Levesque, Denys et al**
**Cabinet Beau de Loménie 55, rue d'Amsterdam**
**F-75008 Paris (FR)**

EP 0 408 435 B1

## Description

L'invention se rapporte aux outillages permettant d'effectuer l'infiltration en phase vapeur d'un matériau au sein de préformes fibreuses en vue de la fabrication de pièces composites, comprenant deux plateaux destinés à enserrer une préforme fibreuse au cours du processus d'infiltration, qui offrent des extrémités débordant de la préforme fibreuse par lesquelles ils sont solidarisés mutuellement avec un écartement convenable déterminé par des éléments de calage prévus dans la région desdites extrémités des plateaux.

Lorsqu'on utilise un outillage de ce genre pour réaliser l'infiltration d'un matériau au sein d'une préforme fibreuse, le matériau d'infiltration forme un dépôt à la surface de l'ensemble de l'outillage, qui crée une surépaisseur modifiant les dimensions de ses éléments constitutifs. Cela nécessite d'effectuer, entre chaque processus d'infiltration, un usinage d'au moins une partie desdits éléments afin de rétablir à leur valeur nominale les cotes de calage critiques qui déterminent les dimensions des pièces à réaliser.

L'usinage intermédiaire qu'implique chaque réutilisation de l'outillage constitue une importante sujétion, d'autant plus que les formes toujours plus complexes des pièces à réaliser, donc des outillages adoptés, rendent cette opération de rénovation délicate et onéreuse.

La présente invention a pour but de remédier à cet inconvénient.

Selon l'invention, aux extrémités d'un plateau où celui-ci offre des faces planes de contact avec les éléments de calage, ce plateau comporte des gorges dont le tracé suit le contour des zones de contact des éléments de calage, la largeur de ces gorges étant telle que, malgré la dispersion de positionnement des éléments de calage due aux jeux de montage des éléments constitutifs de l'outillage, les armes limitant les faces d'appui des éléments de calage qui déterminent lesdites zones de contact se trouvent toujours entièrement comprises entre les bords intérieurs et extérieurs des gorges en regard.

Grâce à la présence de ces gorges, la totalité de la surface de chaque plateau avec laquelle un élément de calage est susceptible de venir en contact reste, après une opération d'infiltration, exempte de surépaisseur due au dépôt du matériau d'infiltration formé dans cette région. Les gorges assurent ainsi la protection des surfaces de référence géométrique de l'outillage et permettent de renouveler le montage de ce dernier sans risque qu'un élément de calage vienne s'appuyer sur le dépôt résultant d'une infiltration précédente, et non sur la surface de calage proprement dite d'un plateau. Cela procure une notable augmentation de la durée de vie de l'outillage sans rénovation intermédiaire par usinage, laquelle ne s'achève qu'au complet remplissage des gorges par les dépôts successifs formés durant de multiples processus d'infiltration.

Lorsque l'outillage est doté de pions de centrage destinés à assurer un positionnement précis des plateaux, chaque pion étant fixé, éventuellement de manière amovible, à l'un des plateaux et traversant l'intervalle qui les sépare pour aller s'emboîter dans une cavité de réception pratiquée dans l'autre plateau, il convient de prévoir en outre, autour de chaque pion, un élément annulaire qui se trouve comprimé entre les deux plateaux lorsque ceux-ci sont amenés à leur écartement convenable et assure la protection du pion par un effet d'étanchéité en le préservant de tout dépôt, lors du processus d'infiltration, qui risquerait d'affecter les possibilités de démontage et de remontage du pion. Cet élément annulaire peut avantageusement être composé d'une rondelle épaisse de feutre de carbone flanquée d'une paire de rondelles minces de métal, par exemple de molybdène.

L'invention s'applique aux outillages pour infiltration de pyrocarbone ou de tout autre matériau constitutif d'une matrice au sein d'une préforme fibreuse et susceptible d'être infiltré en phase vapeur, tel que le carbure de silicium SiC.

D'autres particularités et avantages de l'invention ressortiront de la description qui va suivre, en regard des dessins annexés, d'exemples de réalisation non limitatifs.

La figure 1 représente en coupe une partie d'un outillage classique après une opération d'infiltration.

La figure 2 représente l'outillage de la figure 1 après démontage puis remontage pour réalisation d'une nouvelle infiltration.

La figure 3 représente un tel outillage muni du perfectionnement selon l'invention.

Les figures 4 et 5 représentent deux variantes de réalisation d'un outillage selon l'invention.

La figure 6 représente en coupe une partie d'un outillage comprenant un pion de centrage des plateaux.

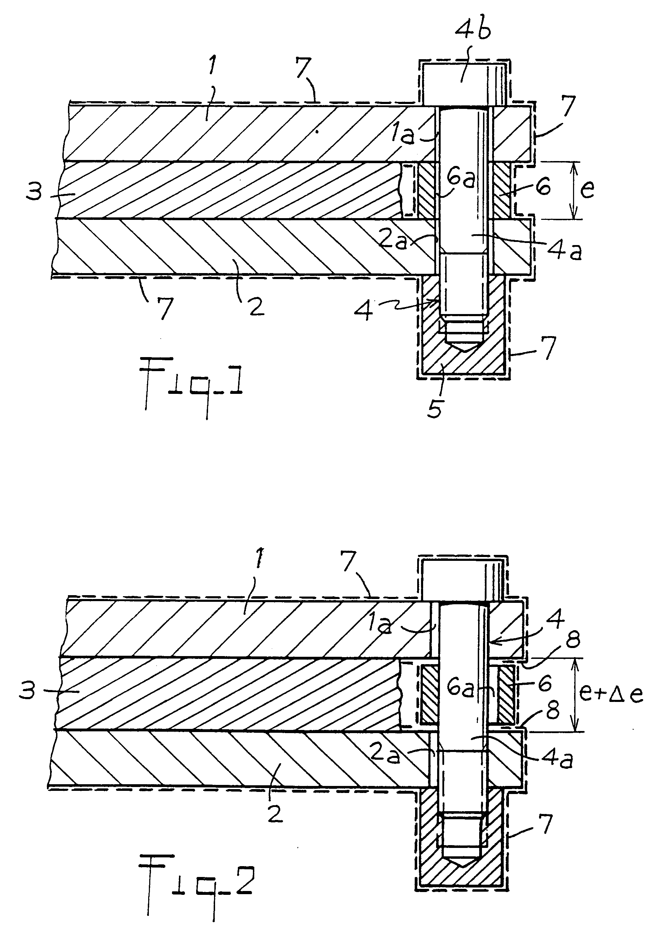

L'outillage représenté partiellement à la figure 1 est composé d'éléments en graphite. Il comprend deux plateaux 1, 2 entre lesquels est placée une préforme 3 de fibres de carbone qui doit être consolidée par infiltration de pyrocarbone en vue de l'obtention d'une pièce composite.

A leurs extrémités débordant de la préforme fibreuse 3, les plateaux 1, 2 sont réunis par des ensembles de liaison comprenant chacun un boulon 4 et un écrou 5 qui se visse à l'extrémité filetée de celui-ci, avec interposition d'éléments de calage constitués par des entretoises annulaires 6. Chacune de ces dernières, engagée sur le fût 4a d'un boulon 4, détermine par son épaisseur, c'est-à-dire par la distance qui sépare ses deux faces annulaires planes et parallèles, l'écartement e des plateaux 1, 2 qui fixe l'épaisseur souhaitée pour la pièce composite à réaliser.

Lors de l'opération de consolidation de la préforme fibreuse 3, le pyrocarbone non seulement vient infiltrer celle-ci, mais également va se déposer sur toutes les surfaces exposées de l'outillage. Un dépôt 7 se forme ainsi sur les faces externes des plateaux 1, 2, sur la tête 4b de chaque boulon 4, sur une portion des faces internes des plateaux 1, 2 entourant les entretoises 6, sur la surface latérale de celles-ci et sur l'écrou 5 correspondant. Restent toutefois préservées les zones de contact des plateaux 1, 2 avec les faces d'appui planes des entretoises 6, qui appartiennent aux surfaces de référence géométrique de l'outillage, ainsi que les surfaces du fût 4a des boulons 4, de l'ouverture centrale des entretoises 6 et des trous qui sont pratiqués aux extrémités des plateaux 1, 2 pour permettre le passage des boulons 4.

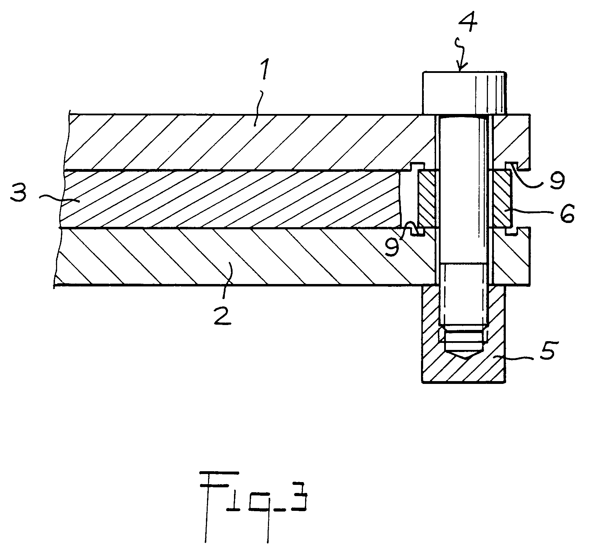

Après achèvement du processus d'infiltration, l'outillage 1, 2, 4, 5, 6 est démonté pour permettre l'extraction de la pièce, puis remonté en vue de la consolidation d'une autre préforme. Comme le montre la figure 2, il peut arriver, en raison du jeu radial existant entre le fût 4a d'un boulon 4 d'une part et les trous 1a, 2a, 6a des plateaux 1, 2 et de l'entretoise 6, d'autre part, qu'une portion du dépôt 7, formée sur les faces internes des plateaux 1, 2 dans les régions 8 voisines de l'entretoise 6, s'interpose, au remontage de l'outillage, entre ces faces et les faces correspondantes de l'entretoise 6. Il en résulte un écartement exagéré e + Δ e des faces internes des plateaux, conduisant à une pièce d'épaisseur incorrecte.

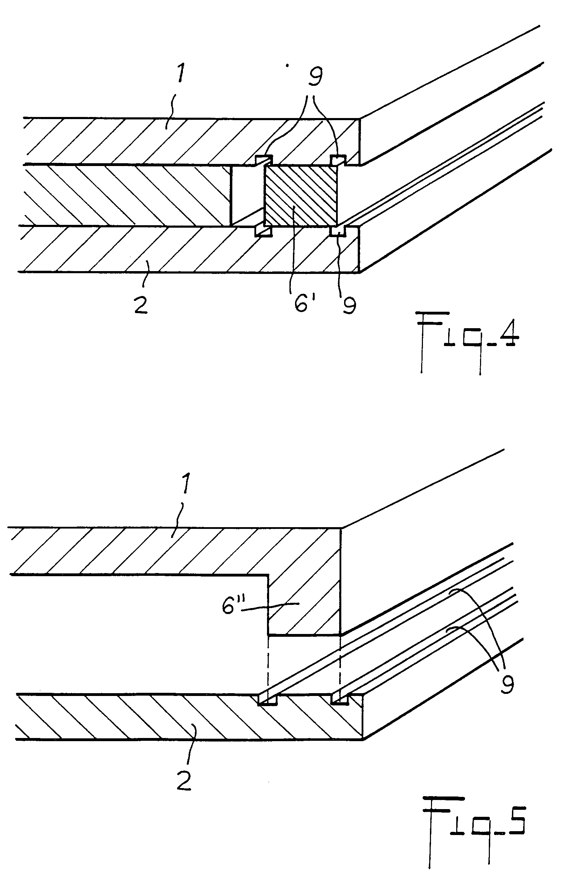

L'outillage représenté à la figure 3 a été aménagé pour éviter pareille éventualité. Une gorge annulaire 9 est creusée dans chacune des faces internes des plateaux 1, 2. Chaque gorge 9 entoure le trou 1a, 2a du plateau 1, 2 respectif suivant un tracé correspondant au contour extérieur de l'entretoise 6, avec une largeur telle que, compte tenu des jeux radiaux précités, l'arête périphérique de chaque face de contact de l'entretoise 6 se trouve toujours entièrement en regard de la gorge correspondante. Ainsi, le dépôt 7 se formant dans chaque gorge 9 ne peut venir s'interposer intempestivement entre les faces internes des plateaux 1, 2 et l'entretoise 6, quel que soit le positionnement de celle-ci entre les plateaux. Ceci reste valable jusqu'à ce que les dépôts de pyrocarbone formés lors d'infiltrations successives parviennent à combler les gorges 9.

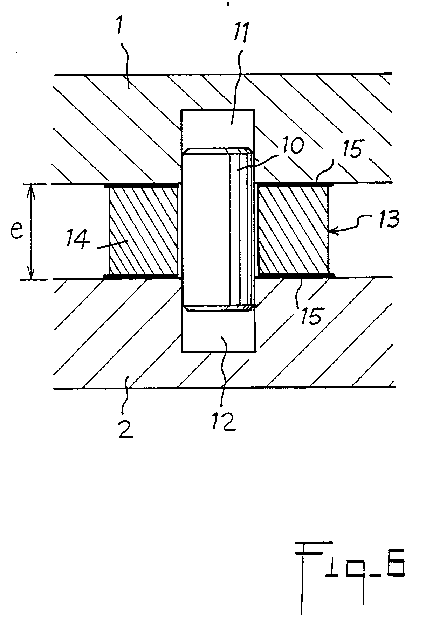

La figure 4 montre une variante dans laquelle les éléments de calage sont constitués non pas par des pièces annulaires, mais par des barres rectilignes 6' de section rectangulaire. Dans ce cas, les gorges 9 s'étendent également en ligne droite le long des arêtes bordant les faces de contact des barres 6'.

Selon la figure 5, les barres 6' peuvent faire partie intégrante de l'un des plateaux. Dans le présent exemple, elles prennent la forme de rebords rectilignes 6'' appartenant au plateau 1, l'ensemble pouvant être consommable. Ici, seul l'autre plateau 2 comporte des gorges 9.

Afin d'assurer un positionnement précis des plateaux 1 et 2 l'un par rapport à l'autre, ceux-ci sont munis de pions de centrage 10 dont l'un est représenté à la figure 6. Chaque pion 10 est engagé dans une cavité de réception conjuguée 11, 12 respectivement ménagée dans l'une et dans l'autre des faces en regard des plateaux 1, 2. Afin d'éviter qu'un dépôt de pyrocarbone se forme sur les pions 10 et les parties avoisinantes des faces internes des plateaux, chaque pion est entouré d'un élément d'étanchéité annulaire 13 composé d'une rondelle 14 de feutre de carbone interposée entre deux rondelles 15 de clinquant de molybdène (ce métal est non polluant pour l'atmosphère du four où est placé l'outillage, résiste aux hautes températures et permet un décollement facile des rondelles de feutre). Lorsque les plateaux 1, 2 sont mis à l'écartement e déterminé par les entretoises de calage en épaisseur, la rondelle 14 se trouve fortement comprimée entre les plateaux et assure, par un effet d'étanchéité, la protection des pions 10, qui restent vierges de tout dépôt intempestif et, de ce fait, peuvent être montés et démontés sans difficulté.

## Revendications

1. Outillage permettant d'effectuer l'infiltration en phase vapeur d'un matériau au sein de préformes fibreuses en vue de la fabrication de pièces composites, comprenant deux plateaux destinés à enserrer une préforme fibreuse au cours du processus d'infiltration, qui offrent des extrémités débordant de la préforme fibreuse par lesquelles ils sont solidarisés mutuellement avec un écartement convenable déterminé par des éléments de calage prévus dans la région desdites extrémités des plateaux,
caractérisé par le fait que, aux extrémités d'un plateau (2) où celui-ci offre des faces planes de contact avec les éléments de calage (6; 6'; 6''), ce plateau comporte des gorges (9) dont le tracé suit le contour des zones de contact des éléments de calage, la largeur de ces gorges étant telle que, malgré la dispersion de positionnement des éléments de calage due aux jeux de montage des éléments constitutifs de l'outillage, les arêtes limitant les faces d'appui des éléments de calage qui déterminent lesdites zones de contact se trouvent toujours entièrement comprises entre les bords intérieurs et extérieurs des gorges en regard.

2. Outillage selon la revendication 1, caractérisé par le fait que les éléments de calage sont constitués par des entretoises (6; 6') interposées entre les faces d'extrémités des plateaux (1, 2), lesquels comportent tous deux des gorges (9) dans lesdites faces.

3. Outillage selon la revendication 1, caractérisé par le fait que les éléments de calage sont constitués par des rebords (6″) appartenant à l'un (1) des plateaux, seul l'autre plateau (2) étant doté de gorges (9) dans ses faces d'extrémités.

4. Outillage selon l'une quelconque des revendications 1 à 3, caractérisé par le fait qu'il est doté de pions de centrage (10) assurant un positionnement précis des plateaux (1, 2), chaque pion étant fixé, éventuellement de manière amovible, à l'un des plateaux et traversant l'intervalle qui les sépare pour aller s'emboîter dans une cavité de réception pratiquée dans l'autre plateau, et qu'autour de chaque pion (10) est prévu un élément annulaire (13) qui se trouve comprimé entre les deux plateaux lorsque ceux-ci sont amenés à leur écartement (e) convenable et assure la protection du pion par un effet d'étanchéité.

5. Outillage selon la revendication 4, caractérisé par le fait que ledit élément annulaire (13) est composé d'une rondelle épaisse (14) de feutre de carbone flanquée d'une paire de rondelles minces (15) de métal, par exemple de molybdène.

## Patentansprüche

1. Werkzeug für die Dampfphaseninfiltration eines Materials ins Innere faseriger Vorformen im Hinblick auf die Herstellung von Verbundwerkstoffen, umfassend zwei Platten, die eine faserige Vorform während des Infiltrationsvorgangs einspannen sollen, und die Enden besitzen, welche über die faserige Vorform hinausragen und durch welche sie fest aneinander befestigt sind, und zwar in entsprechendem Abstand, der durch Keilstücke bestimmt wird, die im Bereich der Plattenenden vorgesehen sind,
dadurch gekennzeichnet, daß eine Platte (2) an ihren Enden, an denen sie über ebene Kontaktflächen mit den Keilstücken (6; 6′; 6″) verfügt, Rillen (9) aufweist, die dem Umriß der Kontaktzonen der Keilstücke folgen, wobei die Breite dieser Rillen auch trotz der weiten Positionierung der Keilstücke, die durch das Montagespiel der Bestandteile des Werkzeugs entsteht, dadurch bestimmt wird, daß die Kanten, die die Auflageseiten der Keilstücke bilden, die die genannten Kontaktzonen bestimmen, sich immer vollkommen zwischen dem Innen- und Außenrand der sich gegenüberliegenden Rillen befinden.

2. Werkzeug gemäß Anspruch 1, dadurch gekennzeichnet, daß die Keilstücke aus Distanzstücken (6; 6′) bestehen, die zwischen die Seiten der Enden der Platten (1,2) gesetzt werden, von denen beide Rillen (9) in den besagten Seiten aufweisen.

3. Werkzeug gemäß Anspruch 1, dadurch gekennzeichnet, daß die Keilstücke aus Leisten (6″) bestehen, die zu einer der beiden Platten (1) gehören, wobei nur die andere Platte (2) an den Seiten der Enden über Rillen (9) verfügt.

4. Werkzeug gemäß einem der Ansprüche 1 bis 3, dadurch gekennzeichnet, daß es über Zentrierstifte (10) verfügt, die die genaue Positionierung der Platten (1, 2) sicherstellen, wobei jeder Stift, eventuell herausnehmbar, an einer der Platten befestigt ist und zwischen beiden Platten durchgesteckt wird und in eine Aufnahmehöhlung faßt, die in der anderen Platte vorgesehen ist, und daß um jeden Stift (10) herum ein ringförmiges Element (13) vorgesehen ist, das zwischen den beiden Platten zusammengedrückt wird, wenn diese in den richtigen Abstand (e) voneinander gebracht werden, und das durch einen Abdichteffekt den Stift schützt.

5. Werkzeug gemäß Anspruch 4, dadurch gekennzeichnet, daß das besagte ringförmige Element (13) aus einer dicken Kohlenstofffilzscheibe (14) besteht, die flankiert ist von einem Paar dünner Scheiben (15) aus Metall, beispielsweise aus Molybdän.

## Claims

1. Tool for carrying out a chemical vapor infiltration of a material within fibrous preforms for the manufacture of composite parts, said tool comprising two plates for clamping a fibrous preform undergoing an infiltration process, said plates having ends overlapping from said fibrous preform whereby said plates are held together with suitable spacing therebetween determined by blocking elements provided in the vicinity of said ends of the plates,
characterized by the fact that the ends of a plate (2) where the latter presents planar contact faces in contact with said blocking elements (6; 6′; 6″) comprise channels (9) extending along a contour of the contact zones of said blocking elements, the width of said channels being such that, irrespective of a variation in the positioning of said blocking elements arising from some play in assembling the elements forming said tool, the edge portions delimiting the bearing faces of the blocking elements that determine said contact zones are always located entirely between the inner and outer edges which are in facing relationship of the channels.

2. Tool according to claim 1, characterized by the fact that the blocking elements are constituted by spacers (6; 6′) interposed between the end faces of plates (1, 2), which plates comprise channels (9) in said faces.

3. Tool according to claim 1, characterized by the fact that the blocking elements are constituted by edge portions (6″) belonging to one (1) of the plates, and only the other plate (2) is provided with channels (9) in its end faces.

4. Tool according to any one of claims 1 to 3, characterized by the fact that it is provided with centering pins (10) to ensure an accurate positioning of plates (1, 2), each pin being fixedly mounted or optionally removably mounted to one of the plates and passing through the gap separating said plates to engage inside a receiving cavity formed in the other plate, and by the fact that each pin (10) is equipped with an annular element (13) which is compressed between the two plates when said plates are brought to their suitable spacing (e) and thus provides protection for the pin by a sealing effect.

5. Tool according to claim 4, characterized by the fact that said annular element (13) is composed of a thick carbon felt washer (14) flanked by a pair of thin metal washers (15), e.g. made of molybdenum.

Fig. 1

Fig. 2

Fig_3

Fig-4

Fig-5

Fig-6